# EUROPÄISCHE PATENTANMELDUNG

(11) **EP 4 757 183 A1**
(43) Veröffentlichungstag der Anmeldung: **10.06.2026**
(21) Anmeldenummer: 25219954.2
(22) Anmeldetag: 02.12.2025
(51) Int. Cl.: H03K 17/95, H05K 1/02, H05K 1/16, H05K 3/46, H01F 27/36

(54) **SPULENPLATINE UND VERFAHREN ZUR HERSTELLUNG EINER SPULENPLATINE**

(30) Priorität: 05.12.2024 DE 102024136312
(71) Anmelder: Turck Holding GmbH, 58553 Halver (DE)
(72) Erfinder: Faber, Michael, 58762 Altena (DE)
(74) Vertreter: DTS Patent- und Rechtsanwälte PartmbB

(57) **Zusammenfassung**

Eine Spulenplatine (101), insbesondere für einen induktiven Näherungsschalter, insbesondere zum bündigen Einbau in eine metallische Umgebung, umfasst ein isolierendes Trägermaterial, zumindest ein Spulenelement (102), das auf oder in dem isolierenden Trägermaterial ausgebildet ist, eine in dem isolierenden Trägermaterial ausgebildete umlaufende und geschlossene Ausnehmung (103), die das Spulenelement (102) umgibt, und ein separates, vorgeformtes Abschirmelement (104), das passgenau in der Ausnehmung (103) angeordnet ist. Ein Verfahren (200) zur Herstellung einer Spulenplatine (101) umfasst die Schritte: Bereitstellen (210) einer Spulenplatine (101), die ein isolierendes Trägermaterial und zumindest ein auf oder in dem isolierenden Trägermaterial ausgebildetes Spulenelement (102) umfasst; Herstellen (220) einer umlaufenden und geschlossenen Ausnehmung (103) in dem isolierenden Trägermaterial, wobei die Ausnehmung (103) das Spulenelement (102) umgibt; und Einsetzen (230) eines separaten, vorgeformten Abschirmelements (104) in die Ausnehmung (103).

## Beschreibung

Die vorliegende Offenbarung betrifft eine Spulenplatine, insbesondere für einen induktiven Näherungsschalter, insbesondere zum bündigen Einbau in eine metallische Umgebung. Ferner betrifft die Offenbarung ein Verfahren zur Herstellung der offenbarten Vorrichtung, insbesondere eines induktiven Näherungsschalters. Weiterhin betrifft die Offenbarung die Verwendung der offenbarten Vorrichtung in einem induktiven Näherungsschalter.

Induktive Näherungssensoren werden in einer Vielzahl industrieller Anwendungen eingesetzt, um die Anwesenheit oder Bewegung von metallischen Objekten zu detektieren. Diese Sensoren arbeiten typischerweise durch die Erzeugung und Auswertung elektromagnetischer Felder, die von einer Spule auf einer Leiterplatte erzeugt werden.

Es sind zwei Hauptausführungen solcher Sensoren bekannt: bündige und nichtbündig einbaubare Näherungssensoren. Bei nicht-bündigen Sensoren ist es erforderlich, dass um die Spule herum ein Abstand zu metallischen Umgebungen eingehalten wird, um eine Beeinträchtigung der Sensorfunktion zu verhindern. Bei bündigen Sensoren wird die Spule direkt an der Frontseite des Sensorgehäuses positioniert, was es ermöglicht, den Sensor in metallische Umgebungen zu integrieren, ohne dass ein Abstand erforderlich ist. Dies ist insbesondere wichtig, wenn der Sensor in eine metallische Umgebung integriert werden soll, beispielsweise in Maschinenkomponenten oder Bodenplatten.

Um die elektromagnetische Spule vor äußeren Störungen durch die metallische Umgebung abzuschirmen, wird häufig eine Abschirmung verwendet. Im Stand der Technik werden Abschirmelemente entweder direkt um die Spule herum angebracht oder mit zusätzlichen Materialien wie Vergussmassen fixiert. Diese Lösungen haben jedoch Nachteile bei der exakten Positionierung und Fixierung der Abschirmung.

In der DE 10 2021 114 948 A1 ist ein Näherungssensor zur induktiven Erfassung von Objekten gezeigt. Der Sensor umfasst ein Gehäuse mit einer Frontkappe, die die Erfassungsseite des Sensors bildet. Eine Prozess- und Empfangseinheit, die eine Leiterplatte enthält, ist mit einer externen Steuer- und/oder Auswerteeinheit verbindbar. Auf einem ein- oder mehrteiligen Spulenträger sind in Achsrichtung beabstandet mindestens eine Primärspule und mindestens eine erste Sekundärspule angeordnet, wobei die Spulen entweder gewickelt oder gedruckt sind. Die Stirnfläche des Spulenträgers liegt unmittelbar der inneren Oberfläche der Frontkappe gegenüber oder ist an dieser anliegend. Dabei ist die Sekundärspule in Achsrichtung näher an der Stirnfläche angeordnet als die Primärspule. Im Achsbereich der zweiten Sekundärspule und um diese herum ist ein metallisches Abschirmelement angeordnet, während im Achsbereich der ersten Sekundärspule kein metallisches Abschirmelement vorgesehen ist.

Ein wesentlicher Nachteil des Standes der Technik besteht darin, dass die Abschirmung von Spulen in induktiven Näherungssensoren oft ungenau positioniert ist und zusätzliche Arbeitsschritte wie das Vergießen oder Kleben des Abschirmelements erfordert. Diese Vorgehensweise erschwert den Fertigungsprozess und führt zu erhöhten Produktionskosten und ungenauen Abschirmeffekten. Zudem kann die unsachgemäße Positionierung des Abschirmelements die Reichweite und Empfindlichkeit des Sensors beeinträchtigen.

Vor dem Hintergrund dieses Standes der Technik besteht die Aufgabe der vorliegenden Offenbarung darin, eine Vorrichtung zum Abschirmen einer Spulenplatine, ein Verfahren zur Herstellung der Vorrichtung und eine Verwendung der Vorrichtung in einem induktiven Näherungsschalter anzugeben, die jeweils geeignet sind, die zuvor genannten Nachteile des Stands der Technik zumindest teilweise zu überwinden und den Stand der Technik zu bereichern.

Die technische Aufgabe besteht insbesondere darin, eine Vorrichtung zu schaffen, die eine exakte Positionierung und Fixierung eines Abschirmelements gewährleistet und gleichzeitig den Fertigungsprozess vereinfacht und optimiert. Insbesondere soll die Vorrichtung die Empfindlichkeit und Reichweite des Sensors durch eine verbesserte Abschirmwirkung optimieren, während die Produktionskosten gesenkt werden.

Gelöst wird die Aufgabe durch die Merkmale der unabhängigen Patentansprüche. Die Unteransprüche haben jeweils optionale Weiterbildungen der Offenbarung zum Inhalt.

Danach wird die Aufgabe gelöst durch eine Spulenplatine, insbesondere für einen induktiven Näherungsschalter, insbesondere für einen induktiven Näherungsschalter, der für den bündigen Einbau in eine metallische Umgebung konzipiert ist. Die Spulenplatine umfasst ein isolierendes Trägermaterial und zumindest ein Spulenelement, das auf oder in dem isolierenden Trägermaterial ausgebildet ist. Ferner weist die Spulenplatine eine in dem isolierenden Trägermaterial ausgebildete umlaufende und geschlossene Ausnehmung auf, die das Spulenelement umgibt. Es ist ferner vorgesehen, dass ein separates, vorgeformtes Abschirmelement passgenau in der Ausnehmung der Spulenplatine angeordnet ist.

Dieses Merkmal hat den technischen Effekt, dass die Spule wirksam gegen elektromagnetische Störeinflüsse abgeschirmt wird. Dies führt zu einer verbesserten Empfindlichkeit und Stabilität des Sensors, da die Abschirmung in der Ausnehmung präzise und stabil positioniert ist, wodurch die Leistung des Sensors erhöht wird.

Im Sinne dieser Offenbarung kann ein induktiver Näherungsschalter als ein berührungsloser Sensor verstanden werden, der auf der Erzeugung und Erfassung von elektromagnetischen Feldern basiert. Solche Schalter erkennen die Annäherung von metallischen Objekten und lösen eine Schaltfunktion aus, ohne dass ein direkter Kontakt notwendig ist. Dabei ist mindestens eine Sende- und/oder Empfängerspule vorgesehen, die für die Erzeugung beziehungsweise Detektion des elektromagnetischen Feldes verantwortlich ist. Der technische Effekt dieser Schalter ist, dass sie eine zuverlässige Erfassung in industriellen Anwendungen ermöglichen, wo mechanische Betätigung nicht praktikabel ist.

Im Sinne dieser Offenbarung wird eine Spulenplatine als eine Leiterplatte verstanden, die ein isolierendes Trägermaterial umfasst. Dieses isolierende Trägermaterial bildet die strukturelle Grundlage der Spulenplatine und ist typischerweise ein elektrisch nichtleitender Werkstoff.

Auf oder in dem isolierenden Trägermaterial ist zumindest ein Spulenelement ausgebildet. Die Spule wird insbesondere nicht als separates Bauteil gewickelt, sondern sie kann beispielsweise in eine Leiterbahnstruktur der Platine integriert sein, was eine kompaktere Bauweise und höhere Effizienz ermöglicht. Das Spulenelement kann etwa eine Planarspule sein, insbesondere eine gedruckte Spule. Das Spulenelement kann beispielsweise als Empfangs- und/oder Sendespule eines induktiven Näherungssensors ausgebildet sein.

Darüber hinaus kann die Spulenplatine zusätzliche elektronische Bauteile enthalten, die auf oder in der Platine ausgebildet sind, sowie entsprechende elektrische Anschlüsse, die es ermöglichen, die Platine als vollwertiges elektronisches Schaltungsmodul zu verwenden. Diese zusätzlichen Komponenten können zum Beispiel Signalverarbeitungsbausteine, Verstärker oder Anschlusspunkte umfassen, um die Funktionsfähigkeit der Spulenplatine in größeren elektronischen Systemen zu gewährleisten. Dies macht die Spulenplatine zu einem vollständigen Modul, das einsatzbereit ist, insbesondere in der Sensorik.

Im Sinne dieser Offenbarung kann der bündige Einbau in eine metallische Umgebung als eine Installation verstanden werden, bei welcher der Sensor, insbesondere zumindest ein Spulenelement des Sensors, flächenbündig mit der metallischen Umgebung, das kann heißen mit der metallischen Oberfläche oder dem Rand einer metallischen Gehäuseöffnung der Maschine beziehungsweise Anlage, wie zum Beispiel eine Tor-Anlage, abschließt, wodurch eine kompakte und mechanisch geschützte Bauweise erzielt wird. Ferner kann ein bündiger Einbau beinhalten, dass das Spulenelement des Sensors zumindest teilweise von metallischen Materialien umgeben ist.

Hingegen ist beim nichtbündigen Einbau eines Sensors, zum Beispiel eines induktiven Näherungsschalters, ein Freiraum um die aktive Fläche herum vorgesehen. In diesem Fall kann vorgesehen sein, dass ein nichtbündig eingebauter Sensor ein Stück weiter aus der metallischen Umgebung heraussteht, insbesondere so, dass die Spulen nicht von metallischem Material umgeben sind.

Die Spulenplatine kann in einem zumindest teilweise metallischen Gehäuse oder in einem nicht-metallischen Gehäuse angeordnet sein. Bei einem nichtbündigen Einbau kann der Sensor aus der Oberfläche der, insbesondere metallischen, Einbauumgebung überstehen, bei einem bündigen Einbau schließt er bündig mit der (metallischen) Einbauumgebung ab.

Im Sinne dieser Offenbarung kann ein Spulenelement als eine Struktur verstanden werden, die aus mehreren Windungen eines leitfähigen Materials, wie Kupfer, besteht. Das Spulenelement kann als Planarspule ausgebildet sein, insbesondere eine gedruckte Spule. Das Spulenelement dient der Erzeugung eines elektromagnetischen Feldes, das für die Funktion eines Sensors,zum Beispiel ein induktiver Näherungsschalter, verwendet wird. Das Spulenelement ist auf der Spulenplatine integriert und kann über mehrere Lagen der Platine verteilt sein. Das zumindest eine Spulenelement kann unter anderem zumindest eine Sende- und/oder eine Empfangsspule umfassen. Das Spulenelement kann in seiner Form polygonal ausgebildet sein. Die zumindest eine Empfangsspule und die zumindest ein Sendespule können insbesondere als eine gedruckte Spule ausgebildet sein. Sie können ferner in Lagen übereinander angeordnet sein.

Das Spulensystem weist eine Spulenplatine auf, auf der zumindest eine erste Empfangsspule und eine Sendespule angeordnet sind. Dabei umfasst die erste Empfangsspule eine Spule, die in ihrer Form polygonal ausgebildet ist.

Im Sinne dieser Offenbarung kann eine "in dem isolierenden Trägermaterial ausgebildete" Ausnehmung oder Einlassung als eine Vertiefung, Grube oder Kavität verstanden, die integraler Bestandteil des isolierenden Trägermaterials ist und dazu dient, ein anderes Bauteil, insbesondere das Abschirmelement, aufzunehmen.

Die Ausnehmung kann auf verschiedene Weisen realisiert werden. Beispielsweise kann die Ausnehmung durch subtraktive Fertigungsverfahren wie Fräsen, Bohren, Ätzen, Laserschneiden oder Wasserstrahlschneiden in ein ursprünglich massives oder bereits gefertigtes isolierendes Trägermaterial eingebracht werden, wobei Material vom Trägermaterial entfernt wird. Ebenso umfasst der Begriff Ausnehmungen, die durch Umformprozesse, wie Prägen, Tiefziehen oder Eindrücken, in das isolierende Trägermaterial geformt werden. Bei diesen Verfahren wird das Material lokal verformt und/oder verschoben, um die gewünschte Vertiefung zu erzeugen, ohne dass substanziell Material abgetragen werden muss.

Ferner kann die Ausnehmung bereits während des primären Herstellungsprozesses des isolierenden Trägermaterials als integraler Bestandteil des Layouts geformt werden. Dies ist beispielsweise bei Spulenplatinen der Fall, die durch Spritzguss von Kunststoffmaterialien oder durch Gießen von Keramik- oder Verbundwerkstoffen hergestellt werden, wobei die Ausnehmung direkt in der Formgebung des isolierenden Trägermaterials berücksichtigt wird.

Entscheidend ist, dass die Ausnehmung eine strukturelle Eigenschaft des isolierenden Trägermaterials selbst darstellt und dem Trägermaterial eine dreidimensionale Geometrie verleiht, die zur Aufnahme eines weiteren Bauteils dient. Sie ist somit nicht lediglich ein Hohlraum, der sich zwischen separat angeordneten Bauteilen bildet und später durch ein Füllmaterial ausgefüllt wird, noch ist sie eine rein auf die Oberfläche aufgebrachte Struktur. Die Ausnehmung beziehungsweise Einlassung gewährleistet eine präzise und stabile Positionierung des darin aufzunehmenden Elements und ermöglicht eine kompakte Bauweise.

Diese Vertiefung kann das Spulenelement vollständig wie ein Burggraben umgeben, sodass das Spulenelement wie eine Insel umschlossen wird. Dabei verläuft die Ausnehmung beispielsweise kontinuierlich und ohne Unterbrechung um das Spulenelement, sodass eine geschlossene ringförmig, insbesondere kreis- oder polygonförmige Vertiefung entsteht. Diese Ausführung ermöglicht es, das Abschirmelement präzise in die gefräste Ausnehmung einzupassen, was eine optimale Abschirmung des Spulenelements gegenüber elektromagnetischen Störeinflüssen gewährleistet. Außerdem ermöglicht dies eine neue Fügetechnik und -verfahren wie zum Beispiel beim Bestücken der Ausnehmung mit dem Abschirmelement, beziehungsweise bei der Bestückung der Spulenplatine.

Ein "separates, vorgeformtes Abschirmelement, das passgenau in der Ausnehmung angeordnet ist", wird im Sinne dieser Offenbarung als ein eigenständiges Bauteil verstanden, das unabhängig von der Spulenplatine hergestellt und in seiner endgültigen, dreidimensionalen Gestalt vor dem Einsetzen in die Ausnehmung geformt wird. "Separat" bedeutet, dass das Abschirmelement ein diskretes Bauteil ist, das nicht integraler Bestandteil der Leiterbahnstruktur der Spulenplatine ist, wie beispielsweise eine gedruckte oder geätzte Schicht auf der Oberfläche der Spulenplatine. Es erhält seine Form und Fixierung auch nicht erst während des Montageprozesses durch das Ausfüllen eines Hohlraums mit einem Füllmaterial, wie etwa einer Vergussmasse. Vielmehr wird es als eigenständiges Objekt gehandhabt und montiert. "Vorgeformt" bedeutet, dass das Abschirmelement seine endgültige oder nahezu endgültige dreidimensionale Gestalt, beispielsweise als Ring, Hülse oder Polygonzylinder, bereits vor dem Einsetzen in die Ausnehmung der Spulenplatine erhalten hat. Diese Vorformung kann durch verschiedene Fertigungsverfahren wie Stanzen, Biegen, Tiefziehen, Gießen, Sintern oder spanende Bearbeitung, wie Fräsen, erfolgen. Typischerweise besteht das separate, vorgeformte Abschirmelement aus einem elektrisch leitfähigen Material, wie beispielsweise Kupfer (Cu), Messing (CuZn) oder anderen geeigneten Metalllegierungen.

Der Zusatz, dass das Abschirmelement "passgenau in der Ausnehmung angeordnet ist" unterstreicht die präzise mechanische Fügung des vorgeformten Abschirmelements in die dafür vorgesehene eingelassene Ausnehmung des isolierenden Trägermaterials. Dies gewährleistet eine exakte und stabile Positionierung des Abschirmelements relativ zum Spulenelement, was eine optimale und reproduzierbare Abschirmwirkung erlaubt. Dies ermöglicht auch eine genaue Abstimmung des Abschirmelements auf die elektromagnetischen Feldstärken des Spulenelements und eine einfache, exakte und reproduzierbare Montage in der eingelassenen Ausnehmung der Spulenplatine.

Es kann außerdem vorgesehen sein, dass das Abschirmelement parallel zu zumindest einer Lage der Spulenplatine angeordnet ist. Im Sinne dieser Offenbarung kann parallel zu zumindest einer Spulenlage bedeuten, dass das Abschirmelement derart in der Ausnehmung angeordnet ist, dass durch die umlaufende und geschlossene Ausbildung der Ausnehmung um das Spulenelement herum, die Ausnehmung wie ein Graben ausgebildet ist. Die Ausnehmung durchdringt die mehrlagige Struktur der Spulenplatine. Das Abschirmelement ist so angeordnet, dass es in einer Ebene liegt, die mindestens einer dieser Lagen der Spulenplatine entsprechen kann. Je nach Dicke des Abschirmelements und der Tiefe der Ausnehmung kann das Abschirmelement parallel zu mehreren Lagen der Spulenplatine ausgerichtet sein, d.h. es kann sich über mehrere Lagen der Spulenplatine erstrecken, wodurch es eine präzise Abschirmung über die gesamte Spulenplatine hinweg ermöglicht.

Somit gewährleistet das Abschirmelement eine elektromagnetische Abschirmung die direkt auf das Spulenelement abgestimmt ist, wodurch die Effektivität der elektromagnetischen Abschirmung der Spulenplatine optimiert und maximiert wird.

Im Sinne dieser Offenbarung kann ein Abschirmelement als ein leitfähiges Bauteil verstanden werden, das in der Ausnehmung der Spulenplatine angeordnet wird. Es dient dazu, elektromagnetische Störungen von außen zu blockieren oder zu reduzieren und die elektromagnetische Integrität des Spulenelements zu bewahren. Das Abschirmelement kann aus einem leitfähigen Material, wie CuZn-Legierungen, beispielsweise Messing (CuZn), oder Kupfer (Cu) bestehen und sorgt dafür, dass das Spulenelement störungsfrei arbeitet.

Das leitfähige Material des Abschirmelements hat den technischen Effekt, dass es eine hohe elektromagnetische Leitfähigkeit bietet und somit elektromagnetische Interferenzen effizient reduziert. Dies verbessert die Stabilität und Funktionsfähigkeit des Sensors, indem äußere Störeinflüsse minimiert werden.

Im Sinne dieser Offenbarung kann ein leitfähiges Material als ein Material verstanden werden, das eine hohe elektrische Leitfähigkeit aufweist und speziell zur Abschirmung von elektromagnetischen Feldern verwendet wird. Typische Materialien umfassen Kupfer (Cu), das aufgrund seiner hohen Leitfähigkeit besonders geeignet ist, sowie Messing (CuZn), das ebenfalls hervorragende Schirmeigenschaften bietet. Der technische Effekt dieser Materialien besteht darin, dass sie eine effiziente Blockierung von elektromagnetischen Störungen ermöglichen, wodurch die Leistung der Vorrichtung gesteigert wird.

Es kann ferner vorgesehen sein, dass das Abschirmelement als separates Bauteil in der Ausnehmung der Spulenplatine angeordnet ist.

Das Abschirmelement als separates Bauteil hat den technischen Effekt, dass es unabhängig von der Spulenplatine gefertigt und präzise in die Ausnehmung eingesetzt werden kann. Dies erleichtert die Montage und ermöglicht es, Materialien und Bauteile flexibler auszuwählen, um spezifischen Anforderungen gerecht zu werden.

Im Sinne dieser Offenbarung kann ein separates Bauteil als ein eigenständiges Bauelement verstanden werden, das nicht fest in die Spulenplatine integriert ist, sondern nachträglich in die Ausnehmung eingesetzt wird. Dies ermöglicht eine flexible Fertigung des Abschirmelements, was wiederum den technischen Effekt hat, dass unterschiedliche Abschirmelemente für verschiedene Anwendungen leicht austauschbar sind, ohne die gesamte Spulenplatine neu herstellen zu müssen.

Es kann ferner vorgesehen sein, dass das Abschirmelement eine geschlossene Form aufweist. Diese geschlossene Form kann beispielsweise ringförmig sein.

Im Sinne dieser Offenbarung kann eine geschlossene Form als eine durchgehende geometrische Struktur verstanden werden, die das Spulenelement vollständig umschließt. Diese geschlossene Form kann beispielsweise ringförmig sein.

Im Sinne der vorliegenden Offenbarung kann ringförmig sowohl eine kreisförmige als auch eine polygonale, beispielsweise rechteckige oder quadratische, Form umfassen.

Im Sinne der vorliegenden Offenbarung wird auch eine quadratische Form mit abgerundeten Ecken als ringförmig angesehen, da sie die Funktion eines umlaufenden Abschirmelements erfüllt. Der technische Vorteil dieser Form liegt in der verbesserten mechanischen Integration in die Ausnehmung der Platine, wodurch die Belastungen beim Einbau reduziert werden und die Positionierung des Abschirmelements stabiler wird.

Des Weiteren hat das Abschirmelement in geschlossener Form den technischen Effekt, dass es eine gleichmäßige und vollständige Abschirmung um das Spulenelement bietet. Dies führt zu einer verbesserten Abschirmwirkung, da elektromagnetische Störungen aus allen Richtungen blockiert werden können. Der geschlossene Pfad des Abschirmelements ermöglicht es, dass sich in ihm ein elektrischer Strom induzieren lässt, der zur Reduktion von unerwünschten elektromagnetischen Feldern beiträgt. Dies bewirkt, dass das Spulenelement stabiler arbeitet, indem Störfelder absorbiert und abgeleitet werden. Der geschlossene Pfad bildet so eine Barriere, die das elektromagnetische Feld des Spulenelements umschließt und es vor äußeren Einflüssen schützt.

Aufgrund dieser Eigenschaften kann das Abschirmelement als Kurzschlussring ausgeführt sein. Ein Kurzschlussring bietet den zusätzlichen Vorteil, dass er durch den induzierten Strom das elektromagnetische Feld der Spule aktiv dämpft und unerwünschte Störungen effektiv abschirmt.

Es kann weiter vorgesehen sein, dass die Ausnehmung und das Abschirmelement dieselbe geschlossene Form aufweisen, sodass die Form des Abschirmelements der Form der Ausnehmung entspricht. Der technische Vorteil dieser Form liegt in der verbesserten mechanischen Integration in die Ausnehmung der Spulenplatine, wodurch die Belastungen beim Einbau des Abschirmelements reduziert werden und die Positionierung des Abschirmelements stabiler wird.

Es kann des Weiteren vorgesehen sein, dass das Abschirmelement kreisförmig ist. Im Sinne dieser Offenbarung kann der Begriff kreisförmig Formen umfassen, die elliptisch, nahezu kreisrund oder exakt kreisrund sind.

Es kann auch vorgesehen sein, dass das Abschirmelement polygonal ausgebildet ist.

Im Sinne dieser Offenbarung kann der Begriff polygonal eine Form mit geraden Seiten und mehreren Ecken umfassen, wie beispielsweise ein Dreieck, Viereck, Sechseck oder andere Vielecke. Der Begriff schließt sowohl symmetrische als auch asymmetrische Vielecke ein.

Es kann ferner vorgesehen sein, dass das Abschirmelement polygonal mit abgerundeten Ecken ausgebildet ist. Der technische Effekt dieser abgerundeten Ecken besteht darin, dass sie eine bessere Passgenauigkeit beim Einsetzen des Abschirmelements in die Ausnehmung der Spulenplatine ermöglichen. Die abgerundeten Ecken erleichtern das Bestücken der Platine und reduzieren das Risiko mechanischer Spannungen oder Passungenauigkeiten während der Montage.

Es kann ferner vorgesehen sein, dass das Spulenelement in zumindest einer Lage der Spulenplatine ausgebildet ist. Ferner kann vorgesehen sein, dass das Abschirmelement in zumindest dieser Lage der Spulenplatine angeordnet ist.

Das Spulenelement in einer oder mehreren Lagen der Spulenplatine hat den technischen Effekt, dass die Empfindlichkeit und elektromagnetische Leistung des Sensors, zum Beispiel ein induktiver Näherungsschalter, verbessert wird, während der Platzbedarf minimiert bleibt. Die Möglichkeit, das Abschirmelement in derselben Lage der Spulenplatine zu integrieren, ermöglicht eine präzise Abstimmung zwischen der Abschirmung und dem Spulenelement, was die Effizienz der Abschirmung weiter erhöht und gleichzeitig den Aufbau der Platine kompakt hält.

Im Sinne dieser Offenbarung kann der Ausdruck - in zumindest einer Lage der Spulenplatine - als eine Anordnung verstanden werden, bei der das Spulenelement in einer oder mehreren Lagen der Spulenplatine integriert ist. Diese Konfiguration optimiert die elektromagnetischen Eigenschaften des Spulenelements, da die Verwendung einer oder mehrerer Lagen eine höhere Induktivität ermöglicht, ohne den Platzbedarf zu erhöhen. Darüber hinaus kann das Abschirmelement in derselben Lage wie das Spulenelement platziert werden, wodurch eine genaue Positionierung und Abstimmung der Abschirmung relativ zum Spulenelement erreicht wird, ohne zusätzliche Bauraumanforderungen zu verursachen.

Durch die Anordnung des Abschirmelements in zumindest einer Lage der Spulenplatine wird die elektromagnetische Abschirmung direkt in die Struktur der Spulenplatine integriert. Dadurch wird die Abschirmwirkung verstärkt, ohne den Bauraum zu vergrößern, was den gesamten Aufbau des Sensors kompakter und effizienter gestaltet.

Es kann ferner vorgesehen sein, dass die flächige Ausdehnung des Spulenelements, 70-90% der flächigen Ausdehnung des Abschirmelements entsprechen kann. Insbesondere kann das Verhältnis 75-85%, insbesondere 77-82%, insbesondere 80% betragen.

Im Sinne dieser Offenbarung kann der Begriff flächige Ausdehnung des Spulenelements im Verhältnis zur flächigen Ausdehnung des Abschirmelements als das Verhältnis der projizierten Fläche des Spulenelements zur Fläche des Abschirmelements verstanden werden. Die flächige Ausdehnung des Spulenelements kann dabei 70-90% der flächigen Ausdehnung des Abschirmelements betragen, wobei 75-85%, insbesondere 77-82%, insbesondere 80% als besonders vorteilhaft angesehen werden.

Das spezifische Verhältnis zwischen der flächigen Ausdehnung des Spulenelements und dem des Abschirmelements hat den technischen Effekt, dass die Abschirmung optimal auf die elektromagnetische Feldstärke des Spulenelements abgestimmt wird. Dies führt zu einer effizienten Reduktion von elektromagnetischen Störungen, ohne die Sensorempfindlichkeit zu beeinträchtigen. Das angegebene Größenverhältnis stellt sicher, dass das Abschirmelement das Spulenelement bestmöglich umschließt, was zu einer verbesserten Leistung des Sensors führt, insbesondere bei der Reduktion von Störeinflüssen an den Rändern.

Die flächige Ausdehnung kann sich auf die geometrische Fläche beziehen, die sowohl das Spulenelement als auch das Abschirmelement auf einer gemeinsamen Ebene einnehmen. Diese flächige Ausdehnung berücksichtigt nicht nur den Durchmesser (bei kreisförmigen oder ringförmigen Strukturen), sondern beschreibt die gesamte 2D-Fläche, die das Spulenelement und das Abschirmelement auf der Spulenplatine beanspruchen, unabhängig von deren Form (zum Beispiel kreisförmig, polygonal).

Der technische Effekt dieser Dimensionierung liegt darin, dass die elektromagnetische Abschirmung das Spulenelement optimal umschließt und die Effizienz der Abschirmung maximiert. Durch das präzise Größenverhältnis wird das elektromagnetische Feld des Spulenelements gezielt abgeschirmt, ohne die Sensorempfindlichkeit zu beeinträchtigen. Insbesondere in den bevorzugten Größenverhältnissen von 75-85% oder 77-82% wird eine präzisere Steuerung der elektromagnetischen Feldverteilung erreicht, wodurch die Abschirmwirkung verbessert, und die elektromagnetische Effizienz optimiert wird.

Des Weiteren kann die Spulenplatine derart ausgebildet sein, dass 40x40 mm große Sensoren, zum Beispiel induktive Näherungsschalter, entstehen. Die Ausnehmung kann derart ausgebildet sein, dass es das Abschirmelement mit Querschnitt von 0,8 x 0,8 mm aufnehmen kann. Dadurch kann die maximale Empfindlichkeit beziehungsweise Reichweite insbesondere in der Mitte erhalten werden und zu weniger Empfindlichkeit am Rand der Spulenplatine führen.

Das Verfahren zur Herstellung einer Spulenplatine im Sinne der vorliegenden Offenbarung umfasst die folgenden Schritte: Bereitstellen einer Spulenplatine, die ein isolierendes Trägermaterial und zumindest ein auf oder in dem isolierenden Trägermaterial ausgebildetes Spulenelement umfasst, Herstellen einer umlaufenden und geschlossenen Ausnehmung in dem isolierenden Trägermaterial, wobei die Ausnehmung das Spulenelement umgibt, und Einsetzen eines separaten, vorgeformten Abschirmelements in die Ausnehmung.

Das Verfahren ist insbesondere dazu geeignet, die vorliegende beschriebene Spulenplatine herzustellen. Es weist daher die entsprechenden Vorteile auf und kann in analoger Weise wie die Spulenplatine weitergebildet werden.

Das Verfahren zur Herstellung hat den technischen Effekt, dass die Herstellung der Vorrichtung effizient durchgeführt werden kann, indem das Abschirmelement präzise in die Ausnehmung der Spulenplatine eingebracht wird. Das Anordnen des Abschirmelements in der Ausnehmung erhöht die elektromagnetische Abschirmwirkung und verbessert die Funktionsfähigkeit des Sensors, insbesondere induktiven Näherungsschalter. Zudem ermöglicht die genauere Platzierung eine kompakte Bauweise und eine höhere Produktionsgenauigkeit.

Im Sinne dieser Offenbarung kann der Begriff Bereitstellen als der Schritt im Herstellungsprozess verstanden werden, bei dem die erforderlichen Komponenten, insbesondere die Spulenplatine und das Spulenelement, vorbereitet und für die Montage verfügbar gemacht werden. Der technische Effekt dieses Schritts ist, dass eine saubere Ausgangsbasis für die anschließenden Verarbeitungsschritte geschaffen wird.

Der Begriff Ausbilden der Ausnehmung beziehungsweise Herstellen der Ausnehmung bezieht sich im Sinne dieser Offenbarung auf den Prozess, bei dem durch eine Fräsung oder Tiefenfräsung eine umlaufende und geschlossene Vertiefung in der Spulenplatine geschaffen wird, um das Abschirmelement aufzunehmen. Der technische Effekt besteht darin, dass eine präzise und gleichmäßige Aufnahme für das Abschirmelement entsteht, was die Abschirmleistung des Sensors verbessert.

Im Sinne dieser Offenbarung kann der Begriff Einsetzen des Abschirmelements als der Prozess verstanden werden, bei dem das Abschirmelement, das aus einem elektrisch leitfähigen Material ausgebildet sein kann, in die zuvor ausgebildete Ausnehmung eingesetzt beziehungsweise darin angeordnet wird. Das Abschirmelement, das in der Ausnehmung positioniert ist, hat den technischen Effekt, dass die elektromagnetische Abschirmung direkt auf das Spulenelement abgestimmt ist, wodurch die Effektivität der Abschirmung maximiert wird.

Es kann ferner vorgesehen sein, dass das Verfahren im Sinne der Offenbarung weiter das Fixieren des Abschirmelements in der Ausnehmung, insbesondere durch Anlöten, umfasst.

Im Sinne dieser Offenbarung kann der Begriff Fixieren des Abschirmelements als der Prozess verstanden werden, bei dem das Abschirmelement in der Ausnehmung der Spulenplatine befestigt wird. Dies kann durch verschiedene Verfahren der mechanischen Befestigung, beispielsweise Anlöten und/oder Kleben, erfolgen.

Das Fixieren des Abschirmelements in der Ausnehmung, insbesondere durch Anlöten, hat den technischen Effekt, dass eine stabile mechanische und elektrische Verbindung zwischen der Spulenplatine und dem Abschirmelement hergestellt wird, was die elektromagnetische Abschirmwirkung langfristig sicherstellt. Diese stabile Verbindung reduziert das Risiko von Bewegungen oder Verschiebungen des Abschirmelements während des Betriebs, was die Langzeitstabilität und Zuverlässigkeit des Sensors erhöhen.

Der Begriff Anlöten beschreibt im Kontext dieser Offenbarung ein Verfahren, bei dem das Abschirmelement durch eine Lötverbindung fest in der Ausnehmung fixiert wird. Der technische Effekt des Anlötens besteht darin, dass eine mechanisch stabile Verbindung zwischen der Spulenplatine und dem Abschirmelement geschaffen wird, die eine zuverlässige Abschirmung und eine langfristige mechanische Stabilität gewährleistet.

Beispielsweise kann das Anlöten realisiert werden, indem ein oder mehrere Lötflächen (Lötpads) am Rand der Spulenplatine platziert werden. So kann das Abschirmelement punktuell angelötet werden.

Es kann ferner vorgesehen sein, dass die Spulenplatine im Sinne der vorliegenden Erfindung in einem induktiven Näherungsschalter, der für den bündigen Einbau in eine metallische Umgebung konzipiert ist, verwendet wird.

Die Verwendung der Vorrichtung in einem induktiven Näherungsschalter zum bündigen Einbau in eine metallische Umgebung hat den technischen Effekt, dass der Sensor nahtlos und ohne hervorstehende Teile in eine metallische Einbauumgebung integriert werden kann. Dies ermöglicht eine kompakte Bauweise, die den Sensor vor mechanischen Beschädigungen schützt und gleichzeitig ein präzises Erkennen von metallischen Objekten gewährleistet. Induktive Näherungsschalter erkennen die Annäherung von metallischen Objekten und lösen eine Schaltfunktion aus, ohne dass ein direkter Kontakt notwendig ist. Der technische Effekt dieser Schalter ist, dass sie eine zuverlässige Erfassung in industriellen Anwendungen ermöglichen, wo mechanische Betätigung nicht praktikabel ist.

Das oben Beschriebene lässt sich mit anderen Worten auf eine mögliche konkretere Ausgestaltung der Offenbarung wie nachfolgend beschrieben zusammenfassen, wobei die nachfolgende Beschreibung als für die Offenbarung nicht einschränkend auszulegen ist.

Spulen sind Bestandteil von induktiven Näherungsschaltern und werden für die Aussendung und Auswertung elektromagnetischer Felder eingesetzt. Dabei können Spulen sowohl mit Kupferdraht in gewickelter Form, oder in Leiterplattentechnik mit gedruckten Kupferleiterbahnen ausgebildet sein. Induktive Näherungsschalter gibt es in zwei unterschiedlichen Ausführungsformen, für den bündigen Einbau in Metall und für den nichtbündigen Einbau mit einer metallfreien Zone um die Sensorspule.

Es soll ein bündiges Spulensystem gemäß der vorliegenden Offenbarung vorgesehen werden, welches allen Anforderungen an den bündigen Einbau in eine metallische Umgebung erlaubt und insbesondere bezüglich des internen Aufbaus und der Fertigung des Sensors, eine Herstellkostenoptimierte Lösung ermöglicht. Durch die Lösung, bei der ein Abschirmelement, zum Beispiel ein Kurzschlussring, in eine Ausnehmung, zum Beispiel eine Tiefenfräsung, einer Spule in Leiterplattentechnik positioniert und fixiert wird, hat man alle Anforderungen an einen bündigen Sensor für eine kostenoptimierte Fertigung erfüllt.

Im Sinne dieser Beschreibung kann ein Spulensystem eine oder mehrere Spulen umfassen, die auf einer Spulenplatine integriert sind, sowie weiteren Komponenten, die zur Signalverarbeitung und Abschirmung dienen. Das Spulensystem umfasst dabei zumindest eine Empfänger- und/oder zumindest eine Sendespule. Darüber hinaus umfasst das Spulensystem nicht nur die Spulen beziehungsweise, Spulenelemente selbst, sondern auch benötige Zuleitungen für zugehörige Elektronik, um eine präzise Erkennung und Verarbeitung elektromagnetischer Felder zu ermöglichen. Solche Systeme sind besonders in Sensoren wichtig, um stabile und exakte Messwerte zu gewährleisten.

Damit induktive Sensoren bündig eingebaut werden können, müssen bei diesen Sensoren die Spulen intern in dem Sensor durch eine leitende Schirmung gegenüber der metallischen Ein- und Aufbau-Umgebung des Sensors abgeschirmt werden. Dies wird durch ein Abschirmelement, zum Beispiel ein Abschirmring und/oder Kurzschlussring, aus CuZn oder Cu, um die Spule sichergestellt. Üblicherweise ist diese Abschirmung ein geschlossener Ring, der um die Spule/ Spulenplatine in eine Frontkappe gelegt wird. Nachteil dieser Lösung ist, dass mit dem Einlegen des Ringes keine feste Verbindung und Positionierung des Abschirmelements in der Frontkappe geschieht. Dies wird erst im weiteren Fertigungsablauf durch einen zusätzlichen Arbeitsgang, zum Beispiel Füllung der Frontkappe mit einem Vergussharz oder der Fixierung des Abschirmelements durch Kleben oder einer Kunststoff-Umspritzung, ausgeführt.

Im Stand der Technik wird entweder eine Standard-Abschirmung, zum Beispiel ein Abschirmring, um die Spule gelegt und mit Vergussmasse fixiert, oder bei gedruckten Spulenplatinen kann die Abschirmung durch eine Kantenmetallisierung erfolgen.

Ein Nachteil der Ausführung im Stand der Technik mit Standard-Abschirmungen wie Abschirmringen ist die Problematik, dass keine fixe Positionierung vor dem Verguss stattfindet, dadurch ist der Transport und das Handling der unvergossenen Baugruppen im laufenden Fertigungsprozess schwierig. Bei einer Kantenmetallisierung ist die geringe Kupferdicke ein Nachteil, diese bietet nicht die gute Abschirmwirkung für die Bündigkeit wie ein massiver Cu- oder CuZn-Ring.

Gemäß der vorliegenden Offenbarung wird ein neuer Aufbau der Spulenplatine mit einem Abschirmelement, insbesondere einem Abschirmring, implementiert. Dabei wird in die Spulenplatine in Richtung der aktiven Sensorfläche (Frontkappenboden) eine Tiefenfräsung beziehungsweise Ausnehmung eingebracht, in die das Abschirmelement eingelegt und somit fest positioniert wird. Es kann eine fixe Positionierung des Abschirmelements gegenüber des Spulenelements, beziehungsweise der Spulenplatine erfolgen. In einem Fertigungsprozess kann die Spulenplatine mit einem Verguss gefüllt werden, sodass dadurch eine endgültige Fixierung des Abschirmelements in der Ausnehmung sichergestellt werden kann. Diese Positionierung des Abschirmelements erzielt eine optimale Abschirmwirkung auf das Spulensystem und benötigt keinen weiteren Fertigungsschritt zur Fixierung in der Frontkappe.

Eine Ausführung gemäß der vorliegenden Offenbarung ist eine Einplatinen-Ausführung, bei der das Spulensystem und die Schaltung auf einer Platine platziert werden. Das Abschirmelement, beispielsweise in Form eines Kurzschlussringes, wird dabei insbesondere quadratisch ausgeführt und parallel zu den vorderen Kupfer-Lagen, in denen das Spulensystem layoutiert ist, in die Tiefenfräsung eingefügt.

Eine weitere Ausführung gemäß der vorliegenden Offenbarung sieht eine Trennung der Spulenplatine und der Elektronikplatine vor. Hierbei wird der Kurzschlussring rund ausgeführt und mit dem maximalen Durchmesser in eine Tiefenfräsung zur Abschirmung positioniert.

Darüber hinaus sind die Ausführung gemäß der vorliegenden Offenbarung möglich als eine Spulenplatine, als Ausführung bei einer kompletten Sensorplatine, Spulensystem inklusive Elektronikschaltung, als Ausführungen für Sensoren in Kunststoffgehäusen zur internen Abschirmung bei bündigen Sensoren und als Ausführungen für Sensoren in zylindrischen Metallgehäusen, um durch die vereinfachten Möglichkeiten der Fügetechnik, bei der Montage der Baugruppen kostengünstiger herstellen zu können.

Vorteile gegenüber dem bisherigen Stand sind eine Abschirmung der Spule durch das Abschirmelement (zum Beispiel Kurzschlussring) nur in der Höhe des Spulensystems und damit eine optimale Nutzung der maximalen Ausbreitung des elektromagnetischen Felds. Damit sind höchste Schaltabstände erreichbar. Durch Positionierung des Abschirmelements (zum Beispiel Kurzschlussrings) in der Ausnehmung (Tiefenfräsung) der Spulenplatine ist eine direkte Positionierung und Fixierung bei der Montage des Gerätes möglich. Dies ist der wesentliche Vorteil bei der Fügetechnik dieser Vorrichtung. Neue Fügetechniken und -verfahren wie zum Beispiel das Bestücken des Abschirmelements bei der Bestückung der Platine, Fixieren des Abschirmelements (Kurzschlussrings), durch Anlöten, nach der Positionierung in der Frontkappe des Sensors.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Offenbarung umfassen auch nicht explizit genannte Kombinationen von zuvor oder im Folgenden bezüglich der in den Weiterbildungen beschriebenen Merkmalen der Offenbarung. Insbesondere wird dabei der Fachmann auch Einzelaspekte als Verbesserung oder Ergänzungen zu der jeweiligen Grundform der vorliegenden Offenbarung hinzufügen. Insbesondere können Merkmale der Vorrichtungsansprüche durch entsprechende Funktionen umgesetzt und/oder ausgeführt werden, wonach diese das Verfahren ergänzen beziehungsweise erweitern. Ferner können Verfahrensschritte durch entsprechende Implementierungsmodule in der Vorrichtung umgesetzt werden. Somit gilt das oben mit Bezug zur Vorrichtung beschriebene analog auch für das Verfahren und entsprechend umgekehrt.

Weitere Einzelheiten und Vorteile der Erfindung sollen nun anhand der in den Zeichnungen dargestellten Ausführungsbeispiele näher erläutert werden.

Es zeigen:
- Fig. 1: schematische Darstellung einer ersten Ausführungsform der Spulenplatine;
- Fig. 2: schematische Darstellung der ersten Ausführungsform ohne Abschirmelement;
- Fig. 3: schematische Darstellung der zweiten Ausführungsform der Spulenplatine;
- Fig. 4: schematische Darstellung der dritten Ausführungsform der Spulenplatine;
- Fig. 5: schematische Darstellung vierten Ausführungsform der Spulenplatine;
- Fig. 6: schematische Darstellung einer einzelnen Lage der ersten Ausführungsform der Spulenplatine mit Schnittachse A;
- Fig. 7: schematische Darstellung eines Querschnitts der ersten Ausführungsform der Spulenplatine;
- Fig. 8: ein Ablaufdiagramm eines offenbarungsgemäßen Verfahrens.

Die beiliegenden Zeichnungen sollen ein weiteres Verständnis der Weiterbildung der Offenbarung vermitteln. Sie veranschaulichen Weiterbildungen und dienen im Zusammenhang mit der Beschreibung der Erklärung von Prinzipien und Konzepten der Offenbarung. Andere Weiterbildungen und viele der genannten Vorteile ergeben sich im Hinblick auf die Zeichnungen. Die Elemente der Zeichnungen sind nicht notwendigerweise maßstabsgetreu zueinander gezeigt.

In den Figuren sind gleiche, funktionsgleiche, und/oder gleich wirkende Elemente, Merkmale und Komponenten - sofern nichts anderes ausgeführt ist - jeweils mit denselben Bezugszeichen zu versehen.

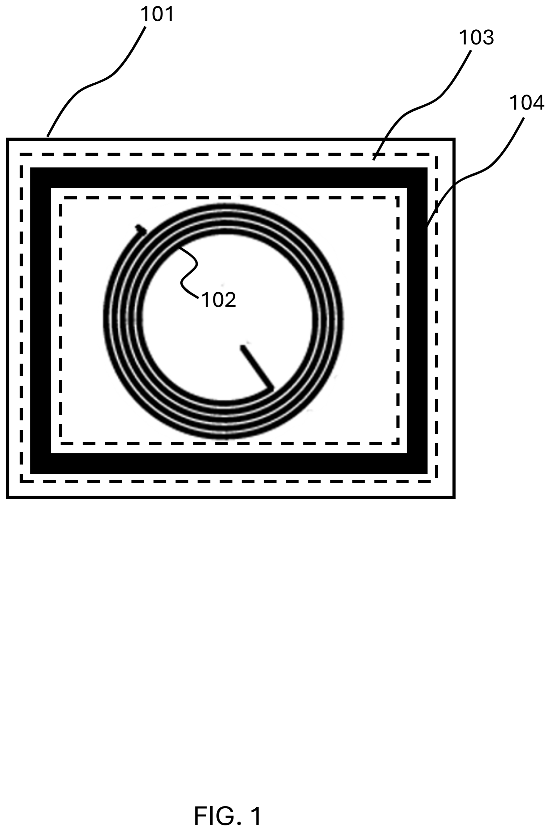

Fig. 1 zeigt eine schematische Darstellung der ersten Ausführungsform der Spulenplatine 101.

Die Spulenplatine 101 umfasst ein isolierendes Trägermaterial.

Ferner ist ein Spulenelement 102 auf oder in dem isolierenden Trägermaterial der Spulenplatine 101 ausgebildet.

Das Spulenelement 102 kann in allen Beispielen der Figuren in der Beschreibung jeweils als Empfänger- oder Sendespule für einen induktiven Näherungssensor ausgebildet sein.

Das Spulenelement 102 ist kreisförmig und spiralförmig ausgebildet.

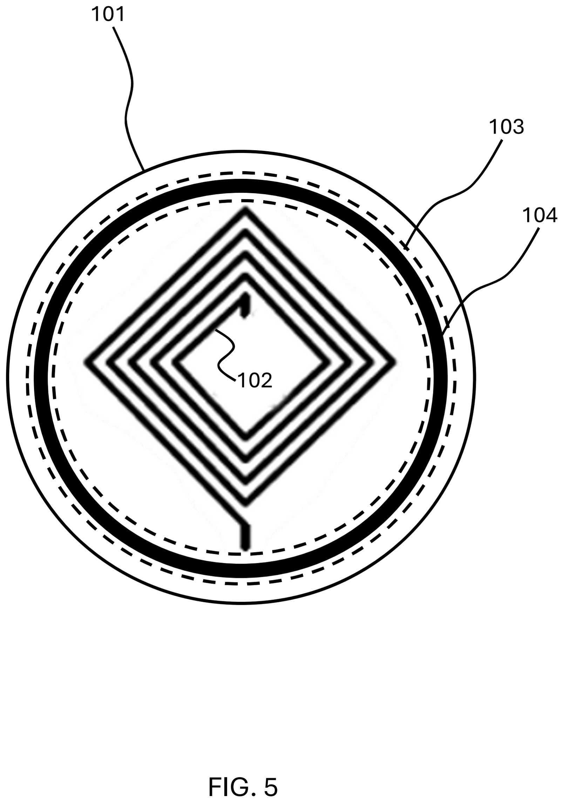

Das Spulenelement 102 kann auch andere Spiralformen ausbilden. Zum Beispiel ist in Fig. 5 eine rautenförmiges Spulenelement 102 gezeigt. Auch andere polygonale Ausführung sind möglich.

Das Spulenelement 102 kann in weiteren Ausführungsbeispielen praktisch beliebige Formen annehmen, solange es innerhalb der Ausnehmung 103 und dem Abschirmelement 104 angeordnet ist.

Das Spulenelement 102 ist in diesem Ausführungsbeispiel als Planarspule ausgebildet.

Das Spulenelement 102 kann in einem weiteren nicht gezeigten Ausführungsbeispiel als gedruckte Spule ausgeführt sein.

Eine umlaufende und geschlossene Ausnehmung 103 ist in dem isolierenden Trägermaterial der Spulenplatine 101 um das Spulenelement 102 eingelassen beziehungsweise darin ausgebildet.

Die Ausnehmung 103 kann zum Beispiel durch eine Fräsung beziehungsweise Tiefenfräsung ausgebildet werden.

Das Abschirmelement 104 ist in der Ausnehmung 103 positioniert und dient der elektromagnetischen Abschirmung des Spulenelements 102.

In diesem Ausführungsbeispiel bildet die Ausnehmung 103 einen quadratisch ringförmigen Bereich um das Spulenelement 102 aus.

Das Abschirmelement 104 ist entsprechend der Ausnehmung 103 geformt. Insbesondere ist das Abschirmelement 104 ebenfalls geschlossen und umlaufend, wie ein quadratischer Ring ausgebildet.

Das Abschirmelement 104 bildet zum Beispiel einen Kurzschlussring aus und dient der elektromagnetischen Abschirmung des Spulenelements 102. Dies gilt für alle Ausführungsbeispiele der Beschreibung.

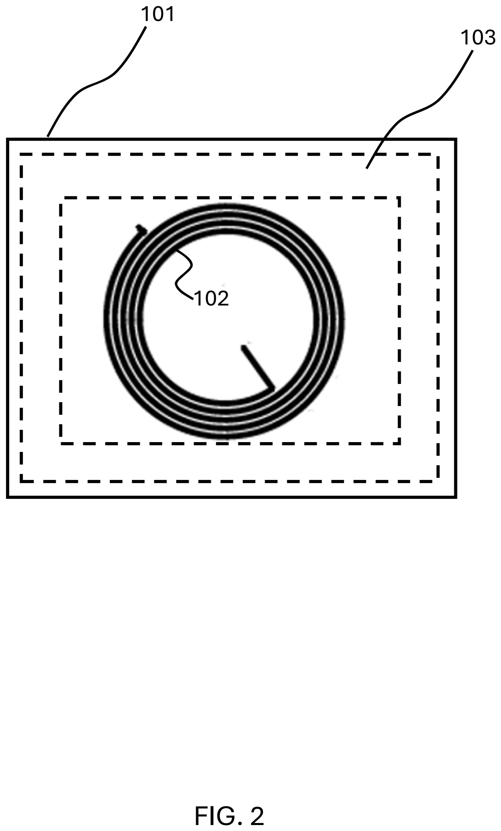

Fig. 2 zeigt ein weiteres Ausführungsbeispiel der Spulenplatine.

In der schematischen Darstellung der Fig. 2 ist die erste Ausführungsform ohne Abschirmelement 104 dargestellt.

Die Spulenplatine 101 ohne das Abschirmelement 104 zeigt die geschlossene umlaufende Ausnehmung 103.

Die umlaufende und geschlossene Ausnehmung 103 ist in der Spulenplatine 101 um das Spulenelement 102 angeordnet. Die Ausnehmung 103 bildet eine Art Burggraben um das Spulenelement 102 aus. Die Ausnehmung 103 dieses Ausführungsbeispiels, und allgemein aller Ausführungsbeispiele der Beschreibung, ermöglicht eine neue Fügetechnik/ -verfahren wie zum Beispiel das Bestücken des Abschirmelements 104, bei der Bestückung der Spulenplatine 101.

Das Spulenelement 102 ist zum Beispiel als gedruckte Planarspule ausgeführt und kreisförmig, insbesondere spiralförmig ausgebildet.

Die Ausnehmung 103 umgibt das Spulenelement 102 vollständig und ist für die Aufnahme des Abschirmelements 104 ausgebildet.

Die Ausnehmung 103 gibt die Form des Abschirmelements 104, beziehungsweise des Kurzschlussrings, vor, da das Abschirmelement 104 in der Ausnehmung 103 angeordnet ist.

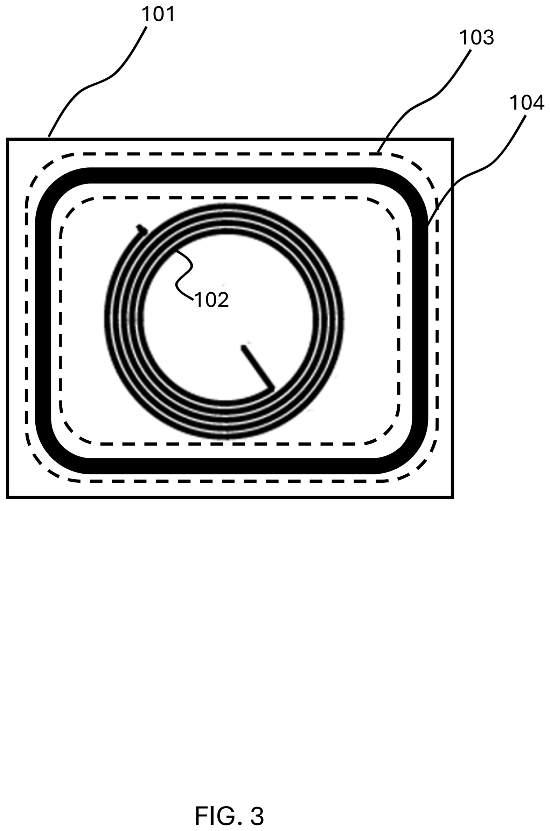

Fig. 3 zeigt ein weiteres Ausführungsbeispiel mit einer schematischen Darstellung der zweiten Ausführungsform der Spulenplatine 101.

Das Spulenelement 102 ist wieder kreisförmig und spiralförmig.

Das Spulenelement 102 ist eine Planarspule und kann zum Beispiel auch als gedruckte Spule ausgebildet sein.

Eine umlaufende Ausnehmung 103 umgibt das Spulenelement 102, wobei das Abschirmelement 104 in der Ausnehmung 103 angeordnet ist, um eine gleichmäßige elektromagnetische Abschirmung sicherzustellen.

Die Ausnehmung 103 und das Abschirmelement 104 sind mit abgerundeten Ecken ausgeführt.

Die abgerundeten Ecken der Ausnehmung 103 und des Abschirmelements 104 gewährleisten eine präzisere Passgenauigkeit in der Spulenplatine 101. Die abgerundeten Ecken reduzieren das Risiko mechanischer Spannungen oder Passungenauigkeiten während der Montage und erleichtern das Einsetzen des Abschirmelements in die Ausnehmung.

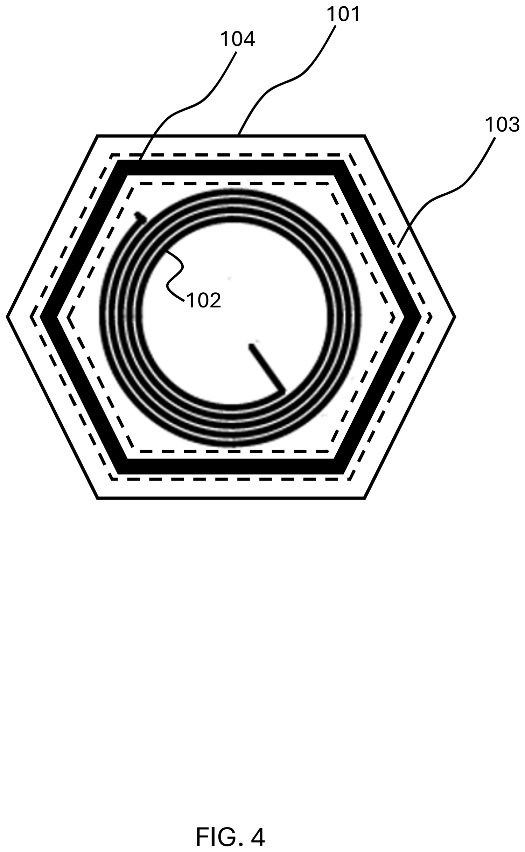

Fig. 4 zeigt ein weiteres Ausführungsbeispiel mit einer schematischen Darstellung der dritten Ausführungsform der Spulenplatine 101.

Die Ausnehmung 103 ist polygonal ausgebildet. Insbesondere ist eine vieleckige, in Fig. 4 speziell eine sechseckige, Ausnehmung 103 ausgebildet.

Die Ausnehmung 103 verläuft um das Spulenelement 102, das kreisförmig und spiralförmig ausgebildet ist.

Das Abschirmelement 104 ist in dieser sechseckigen Ausnehmung 103 platziert und ist wie Ausnehmung 103 ebenfalls polygonal ausgebildet. Insbesondere ist eine vieleckige, in Fig. 4 speziell eine sechseckige, Form des Abschirmelements 104 gezeigt. Das Abschirmelement dient zur elektromagnetischen Abschirmung des Spulenelements 102.

Die polygonale Form des Abschirmelements 104 ermöglicht eine stabile Positionierung in der Ausnehmung 103 und bietet eine gleichmäßige Abschirmung.

Diese Ausführungsform verdeutlicht, dass auch andere polygonale Formen des Abschirmelements 104, wie zum Beispiel fünf oder vieleckige Formen, ebenfalls möglich sind. Dies ist in Fig. 4 zum Beispiel anhand einer sechseckigen Ausführung dargestellt.

Fig. 5 zeigt ein weiteres Ausführungsbeispiel mit einer schematischen Darstellung der vierten Ausführungsform der Spulenplatine 101.

Die Spulenplatine 101 umfasst ein Spulenelement 102, das rauten- und spiralförmig ausgebildet ist.

In anderen Ausführungsbeispielen kann das rautenförmige Spulenelement 102 zum Beispiel anstelle oder in Kombination mit dem kreis- und spiralförmigen Spulenelement 102 verwendet werden, sodass die Ausnehmung 103 und das Abschirmelement 104 in beliebiger geschlossener und umlaufender Form das Spulenelement 102 umgeben.

Die Ausnehmung 103 ist kreisförmig ausgebildet.

In dieser kreisförmigen Ausnehmung 103 ist ein Abschirmelement 104 angeordnet, das ebenfalls eine kreisförmige Ausgestaltung aufweist.

Diese kreisförmige Ausführung ist zum Beispiel eine spezielle Form einer ringförmigen Struktur.

Der kreisförmige Aufbau des Abschirmelements 104 bietet eine gleichmäßige Abschirmwirkung um das Spulenelement 102, da durch die kontinuierliche Form elektromagnetische Störungen aus allen Richtungen effektiv reduziert werden. Dies führt zu einer verbesserten Stabilität und Empfindlichkeit des Sensors, da sich keine ungeschützten Bereiche ergeben und die elektromagnetische Abschirmung optimiert ist.

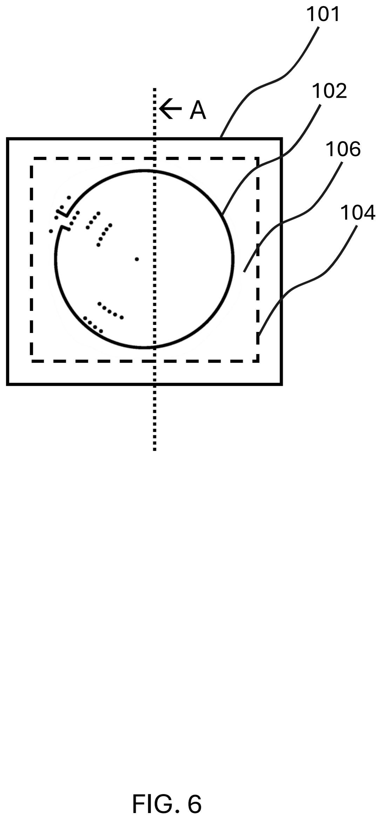

Fig. 6 zeigt eine schematische Darstellung einer einzelnen Lage der ersten Ausführungsform der Spulenplatine mit einer Schnittachse A.

In Fig. 6 ist beispielhaft eine Lage 106 der Spulenplatine dargestellt.

Des Weiteren ist ein Ausschnitt einer Spulenplatine 101 mit einem schematisch dargestellten rechteckigen Abschirmelement 104 gezeigt, das das Spulenelement 102 umschließt.

Das Spulenelement 102 ist in einer Lage 106 der Spulenplatine 101 angeordnet.

Das Abschirmelement 104 mit der Ausnehmung 103 ist in derselben Lage angeordnet und sorgt für eine direkte Abschirmung des Spulenelements 102.

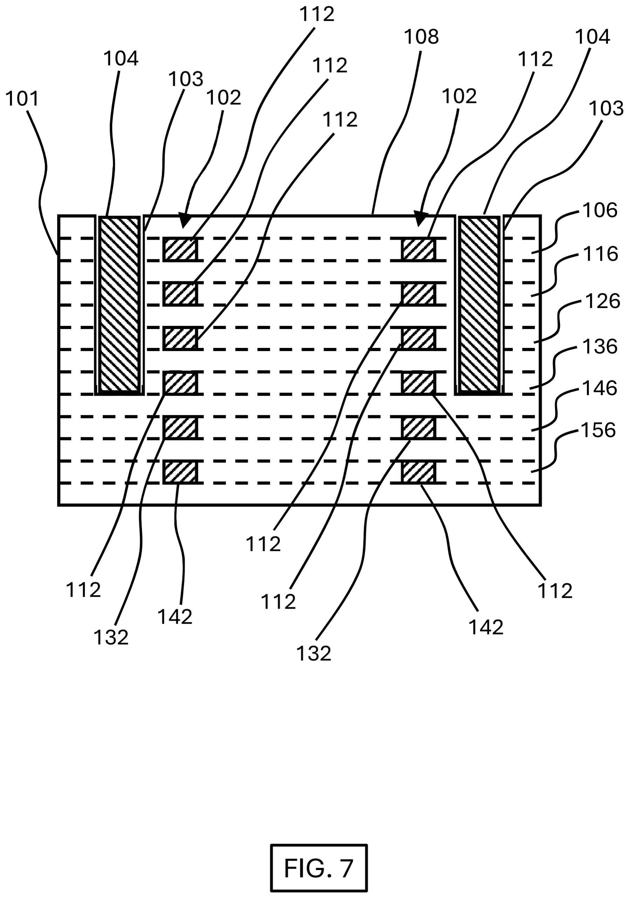

Fig. 7 zeigt die schematische Darstellung eines Querschnitts entlang der Schnittachse A aus Fig. 6. Hierbei handelt es sich beispielhaft um die Spulenplatine 101 der ersten Ausführungsform. Es kann jede beliebige andere Ausführungsform der Beschreibung entlang der Schnittachse A dargestellt werden.

In dieser Darstellung wird eine weitere Ausführungsform der Spulenplatine 101 mit einem Spulenelement 102 und Windungen 112 gezeigt, das zumindest in einer der Lagen 106, 116, 126, 136 der Spulenplatine 101 ausgebildet ist.

Wie in Fig. 6 dargestellt ist eine Lage des Spulenelements 102 kreisförmig ausgebildet, weshalb in der Darstellung der Fig. 7 der Querschnitt der Spulenplatine 101 symmetrisch ausgebildet ist.

Das Spulenelement 102 ist symmetrisch ausgebildet und zeigt jeweils zwei Ausschnitte der Windungen 112 des Spulenelements 102.

Ebenso ist das Abschirmelement 104 und die Ausnehmung 103 symmetrisch ausgebildet

Die Spulenplatine 101 besteht aus mehreren Lagen, darunter die Kupfer-Lagen 106, 116, 126, 136, 146, 156 in denen die elektrisch leitenden Windungen 112 des Spulenelements 102 ausgebildet sind. Diese Kupfer-Lagen können auch das leitfähige Material enthalten, das die Windungen von weiteren Spulenelementen 132, 142 bildet.

Die Windungen der weiteren Spulenelemente 132, 142 können auch als Windungen 112 desselben Spulenelements 102 ausgebildet sein, sodass das Abschirmelement 104 in der Ausnehmung 103 auf der Höhe der Windungen 112 in den Lagen 106, 116, 126, 136 angeordnet ist und die Windungen der weiteren Spulenelemente 132, 142 nicht von der Ausnehmung 103 und dem Abschirmelement 104 umgeben sind.

Die Schichten zwischen den Lagen 106, 116, 126, 136, 146, 156 können zum Beispiel als Isolationsschichten dienen. In diesen Isolationsschichten können zusätzliche leitfähige Bereiche zur Kontaktierung der Windungen und weiterer Elemente angeordnet sein.

Diese mehrschichtige Anordnung ermöglicht eine kompakte Bauweise, ohne die elektromagnetische Abschirmwirkung des Abschirmelements 104 in der Ausnehmung 103 zu beeinträchtigen.

Das Spulenelement 102 ist mehrlagig ausgebildet und umfasst zumindest zwei Spulenlagen, insbesondere die vier Spulenwindungen 112 in den Lagen 106, 116, 126, 136.

Das Abschirmelement 104 und die Ausnehmung 103 ist parallel zu dem Spulenelement 102 ausgebildet. Wie in Fig. 7 genauer dargestellt ist das Abschirmelement 104 parallel zu zumindest einer Lage 106, 116, 126, 136 des Spulenelements 102 beziehungsweise der Spulenplatine 101 angeordnet. Das bedeutet, dass die Ausnehmung 103 wie ein Graben ausgebildet ist, umlaufend und geschlossen um das Spulenelement 102 herum. Dadurch durchdringt die Ausnehmung 103 die mehrlagige Struktur der Spulenplatine 101 und den mehrlagigen Aufbau des Spulenelements 102. Das Abschirmelement 104 ist dementsprechend so angeordnet, dass es zumindest in einer Ebene liegt, die mindestens einer Ebene der Lagen 106, 116, 126, 136 der Spulenplatine entspricht und somit zu dieser oder weiteren Lagen 146, 156 parallel angeordnet ist. Somit ist das Abschirmelement 104 parallel zu dem Spulenelement 102 ausgebildet.

Je nach Ausführung, d.h. Dicke beziehungsweise Höhe, des Abschirmelements 104 und der Tiefe der Ausnehmung 103 kann sich das Abschirmelement 104 über mehrere Lagen 106, 116, 126, 136 der Spulenplatine 101 erstrecken, wodurch es eine präzise Abschirmung der Windungen 112 in den Lagen 106, 116, 126, 136 der Spulenplatine 101 ermöglicht.

Somit gewährleistet das Abschirmelement 104 eine elektromagnetische Abschirmung die direkt auf das Spulenelement 102 abgestimmt ist, wodurch die Effektivität der elektromagnetischen Abschirmung der Spulenplatine 101 optimiert und maximiert wird.

Insbesondere ist das Abschirmelement 104 und die Ausnehmung 103 derart ausgebildet, dass sie über mehrere Lagen 106, 116, 126, 136 ausgebildet sind.

Dabei wird die mehrlagige Spule 102 mit den Spulenwindungen 112 in den Lagen 106, 116, 126, 136 vom Abschirmelement 104 und von der Ausnehmung 103 umschlossen.

Die Lagen 146, 156 mit den weiteren Spulenelementen 132, 142 sind nicht von dem Abschirmelement 104 und der Ausnehmung 103 umfasst.

Die weiteren Spulenelemente 132, 142 können zum Beispiel auch Windungen eines weiteren Spulenelements sein.

Die mehrlagige Spule 102 mit den Windungen 112 und die weiteren Spulenelemente 132, 142 können zum Beispiel jeweils Sende- und/oder Empfängerspulen sein.

Diese Konfiguration zeigt, wie das Abschirmelement 104 präzise relativ zum mehrlagigen Spulenelement 102 mit den Windungen 112 positioniert werden kann, was eine optimale elektromagnetische Abschirmung gewährleistet, ohne den Platzbedarf zu erhöhen.

Die mehrlagige Anordnung des Spulenelements 102 verbessert die Empfindlichkeit und elektromagnetische Leistung des Sensors, zum Beispiel des induktiven Näherungssensors, während das Abschirmelement 104 präzise über mehrere Lagen 106, 116, 126, 136 der Spulenplatine 101 hinweg integriert ist.

In einem weiteren Ausführungsbeispiel, welches in den Figuren nicht dargestellt ist, kann das Abschirmelement 104 und die Ausnehmung 103 auch bis in die tieferen Lagen 146, 156 ausgebildet sein.

Darüber hinaus kann in einem weiteren nicht dargestellten Ausführungsbeispiel die Ausnehmung 103 tiefer ausgebildet sein, als das das Abschirmelement 104 hoch ist. Das bedeutet, die Ausnehmung 103 ist zum Beispiel von der Oberfläche 108 der Spulenplatine 101 bis in die Lage 156 tief ausgebildet, wobei das Abschirmelement 104 lediglich von der Lage 126 bis zur Lage 156 ausgebildet ist.

Die Spulenplatine in den Fig. 1 bis 7 ist als bündig einbaubarer induktiver Näherungssensor konzipiert, vor allem als bündig in einer metallischen Umgebung einbaubarer induktiver Näherungssensor, bei dem die Abschirmung des Spulenelements 102 durch das Abschirmelement 104 in der Höhe des Spulenelements 102 erfolgt. Dadurch wird die maximale Ausbreitung des elektromagnetischen Felds optimal genutzt, was zu höchsten Schaltabständen führt.

Außerdem kann das Spulenelement 102 verschiedene Formen annehmen, zum Beispiel spiralförmig in Kombination mit kreis- und rautenförmigen Ausbildungen. Die Positionierung des Abschirmelements 104 in der Ausnehmung 103 der Spulenplatine 101 ermöglicht eine direkte und präzise Fixierung während der Montage.

Die Ausnehmung 103 wird in den Ausführungsbeispielen durch eine Fräsung oder Tiefenfräsung ausgebildet.

Dies stellt einen wesentlichen Vorteil bei der Fügetechnik dieser Vorrichtung dar. Neue Fügetechniken und -verfahren, wie das Einsetzen des Abschirmelements bei der Bestückung der Platine sowie das Fixieren des Abschirmelements durch Anlöten nach der Positionierung in einer Frontkappe des Sensors, tragen zusätzlich zu einer verbesserten Produktionsgenauigkeit und Stabilität bei.

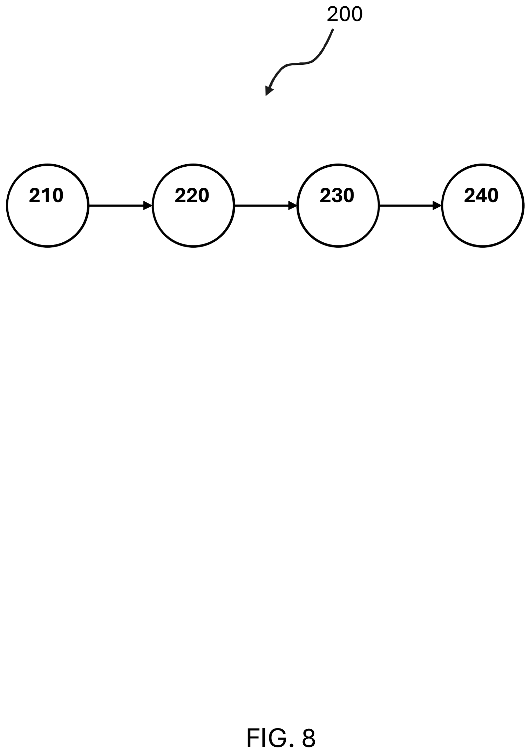

Fig. 8 zeigt ein Ablaufdiagramm eines offenbarungsgemäßen Verfahrens.

Insbesondere ist eine schematische Übersicht über den gesamten Fertigungsprozess der Spulenplatine 101 gezeigt. Der dargestellte Prozess beginnt mit einem Schritt 210, dem Bereitstellen der Spulenplatine 101, die ein isolierendes Trägermaterial und ein Spulenelement 102 umfasst. Das Spulenelement 102 ist dabei auf oder in dem isolierenden Trägermaterial ausgebildet. In einem nächsten Schritt 220 wird eine umlaufende und geschlossene Ausnehmung 103 in der Spulenplatine 101 hergestellt beziehungsweise ausgebildet, wobei diese Ausnehmung 103 das Spulenelement 102 umgibt. In einem weiteren Schritt 230 erfolgt das Einsetzen eines separaten, vorgeformten Abschirmelements 104 in die Ausnehmung 103 beziehungsweise das Anordnen des Abschirmelements 104 in der Ausnehmung 103.

In einem weiteren Schritt 240 des Ausführungsbeispiels wird das Abschirmelement 104 in der Ausnehmung 103 fixiert, um eine stabile und zuverlässige Positionierung zu gewährleisten, beispielsweise durch Anlöten.

Der in diesem Beispiel gezeigte schematische Ablauf stellt eine effiziente und präzise Methode zur Herstellung der Spulenplatine dar. Neue Fügetechniken und - verfahren, wie etwa das Einsetzen des Abschirmelements bei der Bestückung und Fixierung der Spulenplatine, tragen zusätzlich zu einer verbesserten Produktionsgenauigkeit und Stabilität bei.

### Bezugszeichenliste

- 101: Spulenplatine
- 102: Spulenelement
- 103: Ausnehmung
- 104: Abschirmelement
- 106, 116, 126, 136, 146, 156: Lage
- 108: Oberfläche
- 112: Windungen
- 132, 142: weitere Spulenelemente
- 200: Verfahren zur Herstellung
- 210 bis 240: Verfahrensschritte

## Patentansprüche

1. Spulenplatine (101), insbesondere für einen induktiven Näherungsschalter, insbesondere zum bündigen Einbau in eine metallische Umgebung, umfassend:
- ein isolierendes Trägermaterial;
- zumindest ein Spulenelement (102), das auf oder in dem isolierenden Trägermaterial ausgebildet ist;
- eine in dem isolierenden Trägermaterial ausgebildete umlaufende und geschlossene Ausnehmung (103), die das Spulenelement (102) umgibt; und
- ein separates, vorgeformtes Abschirmelement (104), das passgenau in der Ausnehmung (103) angeordnet ist.

2. Spulenplatine (101) nach dem unmittelbar vorhergehenden Anspruch, **dadurch gekennzeichnet, dass** das Abschirmelement (104) aus einem leitfähigen Material, insbesondere Messing (CuZn) oder Kupfer (Cu), ausgebildet ist.

3. Spulenplatine (101) nach einem der vorhergehenden Ansprüche, **dadurch gekennzeichnet, dass** das Abschirmelement (104) als separates Bauteil in der Ausnehmung (103) der Spulenplatine (101) angeordnet ist.

4. Spulenplatine (101) nach einem der vorhergehenden Ansprüche, **dadurch gekennzeichnet, dass** das Abschirmelement (104) eine geschlossene Form aufweist, insbesondere ringförmig.

5. Spulenplatine (101) nach Anspruch **4, dadurch gekennzeichnet, dass** die Ausnehmung (103) und das Abschirmelement (104) dieselbe geschlossene Form aufweisen, sodass die Form des Abschirmelements (104) der Form der Ausnehmung (103) entspricht.

6. Spulenplatine (101) nach Anspruch 4, **dadurch gekennzeichnet, dass** das Abschirmelement (104) kreisförmig ist.

7. Spulenplatine (101) nach Anspruch 4, **dadurch gekennzeichnet, dass** das Abschirmelement (104) polygonal ist.

8. Spulenplatine (101) nach Anspruch 7, **dadurch gekennzeichnet, dass** das Abschirmelement (104) polygonal mit abgerundeten Ecken ausgebildet ist

9. Spulenplatine (101) nach einem der vorhergehenden Ansprüche, **dadurch gekennzeichnet, dass** das Spulenelement (102; 112, 122, 132, 142) in zumindest einer Lage (106, 116, 126, 136, 146, 156) der Spulenplatine (101) ausgebildet ist und das Abschirmelement (104) in zumindest dieser Lage (106, 116, 126, 136, 146, 156) angeordnet ist.

10. Spulenplatine (101) nach einem der vorhergehenden Ansprüche, **dadurch gekennzeichnet, dass** die flächige Ausdehnung des Spulenelements (102), 70 - 90 % der flächigen Ausdehnung des Abschirmelements (104) entspricht.

11. Verfahren (200) zur Herstellung einer Spulenplatine (101) nach einem der vorhergehenden Ansprüche, die Schritte:
- Bereitstellen (210) einer Spulenplatine (101), die ein isolierendes Trägermaterial und zumindest ein auf oder in dem isolierenden Trägermaterial ausgebildetes Spulenelement (102) umfasst;
- Herstellen (220) einer umlaufenden und geschlossenen Ausnehmung (103) in dem isolierenden Trägermaterial, wobei die Ausnehmung (103) das Spulenelement (102) umgibt; und
- Einsetzen (230) eines separaten, vorgeformten Abschirmelements (104) in die Ausnehmung (103).

12. Verfahren nach Anspruch 11, weiter umfassend:
- Fixieren (240) des Abschirmelements (104), insbesondere durch Anlöten, in der Ausnehmung (103).

13. Verwendung der Spulenplatine (101) nach einem der Ansprüche 1 bis 10 in einem induktiven Näherungsschalter, der für den bündigen Einbau in eine metallische Umgebung konzipiert ist.
